(19) Europäisches Patentamt
European Patent Office
Office européen des brevets

(11) EP 0 892 411 B1

(12) EUROPEAN PATENT SPECIFICATION

(45) Date of publication and mention of the grant of the patent:
**19.09.2007 Bulletin 2007/38**

(51) Int Cl.:
***H01G 9/20*** *(2006.01)* ***H01L 51/42*** *(2006.01)*

(21) Application number: **98113194.9**

(22) Date of filing: **15.07.1998**

(54) **Methine dye sensitized semiconductor particle**

Mit Methinfarbstoffen sensibilisierte Halbleiterteilchen

Particules à semi-conducteur sensibilisés par des chromophores méthines

(84) Designated Contracting States:
**AT BE CH CY DE DK ES FI FR GB GR IE IT LI LU MC NL PT SE**

(30) Priority: **15.07.1997 JP 19031597**

(43) Date of publication of application:
**20.01.1999 Bulletin 1999/03**

(73) Proprietor: **FUJIFILM Corporation**
**Minato-ku**
**Tokyo (JP)**

(72) Inventors:
- **Watanabe, Tetsuya**
  **Minami-Ashigara-shi,**
  **Kanagawa (JP)**
- **Tsukahara, Jiro**
  **Minami-Ashigara-shi,**
  **Kanagawa (JP)**

(74) Representative: **Grünecker, Kinkeldey, Stockmair & Schwanhäusser**
**Anwaltssozietät**
**Maximilianstrasse 58**
**80538 München (DE)**

(56) References cited:
**WO-A-94/05025** **WO-A-95/29924**

- **N. J. CHEREPY, G. P. SMESTAD, M. GRÄTZEL, J. Z.. ZHANG: "Ultrafast Electron Injection: Implications for a Photoelectrochemical Cell Utilizing an Anthocyanin Dye-Sensitized tiO2 Nanocrystalline Electrode" J. PHYS. CHEM. B, vol. 101, 1997, pages 9342-9351, XP002116793**
- **H. TRIBUTSCH: "Elektrochemische Untersuchung über die Sensibiliserungseigenschaften und das photochemische Verhalten von Pseudoisocyanin-Farbstoffaggregaten an ZnO-Elektroden" BER. BUNSENGES. PHYS. CHEM., vol. 73, no. 6, 1969, pages 582-590, XP002124850**
- **YOA-CHUN SHEN ET AL: "FABRICATION, CHARACTERIZATION AND PHOTOVOLTAIC STUDY OF A TIO2 MICROPOROUS ELECTRODE" THIN SOLID FILMS,CH,ELSEVIER-SEQUOIA S.A. LAUSANNE, vol. 257, no. 1, page 144-146 XP000496981 ISSN: 0040-6090**
- **J. E. MOSER, M. GRÄTZEL: "Observation of temperature independent heterogeneous electron transfer reactions in the inverted Marcus region" CHEM. PHYS., vol. 176, 1993, pages 493-500, XP002124851**

EP 0 892 411 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

FIELD OF THE INVENTION

The present invention relates to a semiconductor particle having a surface on which a methine dye is adsorbed, a photovoltaic element using the particles and a photo-electrochemical cell using the element.

BACKGROUND OF THE INVENTION

A photovoltaic element is used in various photosensors, copying machines and photovoltaic devices. The photovoltaic elements can be classified into a method using a metal, a method using a semiconductor, a method using an organic pigment or a dye and a complex method.

The semiconductor method uses semiconductor particles spectrally sensitized with a dye. U.S. Patent Nos. 4,684,537, 5,084,365, 5,350644, 5,463,057, 5,525,440 and Japanese Patent Provisional Publication No. 7(1995)-249790 disclose the semiconductor particles spectrally sensitized with a dye. The spectral sensitizing dyes used in the publications are usually ruthenium complexes, which are rather expensive.

Japanese Patent Provisional Publication No. 7(1995)-249790 further describes that a methine dye such as a cyanine dye or a merocyanine dye can be used as a spectral sensitizing dye for the semiconductor particles. The methine dye has been researched and developed as a spectral sensitizing dye for silver halide grains of a silver halide photographic material. Various methine dyes are practically used in a large scale in the technical field of the silver halide photography. Therefore, many methine dyes, which are inexpensive and excellent in optical characteristics are known in the silver halide photography.

WO 95/29924 describes a dye-sensitized solar cell comprising ruthenium dyes having polypyridyl ligands with phosphonate substituents.

SUMMARY OF THE INVENTION

In the silver halide photographic material, the methine dye is adsorbed on the surface of silver halide grains. Therefore, the adsorption of the methine dye on the surface of the silver halide grain has been intensively investigated in the technical field of the silver halide photography.

The present inventors have studied the adsorption of a cyanine or merocyanine dye on the surface of semiconductor particles, and found that there is a large difference between silver halide grains and the semiconductor particles in the ad-sorption of the methine dye. A photographic cyanine or merocyanine dye is not sufficiently adsorbed on the surface of the semiconductor particles, even though the dye is well adsorbed on the surface of silver halide grains. The spectral sensitizing effect depends on the amount of the adsorbed dye.

An object of the present invention is to improve adsorption of a cyanine or merocyanine dye on a surface of semiconductor particles.

Another object of the invention is to provide a semiconductor particle having a surface on which a cyanine or merocyanine dye is sufficiently adsorbed.

A further object of the invention is to provide a photovoltaic element containing sufficiently spectrally sensitized semiconductor particles

A furthermore object of the invention is to provide a photo-electrochemical cell using a photovoltaic element of a high photovoltaic effect.

The present invention provides a semiconductor particle having a surface on which a cyanine or merocyanine dye is adsorbed, according to claim 1 on claim 3
wherein the cyanine or merocyanine dye has a phosphoric group of the formula (P) as a substituent group:

(P)

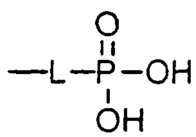

in which L is a single bond, -O-, -S- or -NH-; and the hydrogen atoms may be dissociated from the oxygen atoms.

The invention also provides a photovoltaic element according to claim 5 comprising a conductive support and a light-sensitive layer containing semiconductor particles spectrally sensitized with a cyanine or merocyanine dye, wherein

the cyanine or merocyanine dye has a phosphoric group of the formula (P) as a substituent group.

The invention further provides a photo-electrochemical cell comprising a photovoltaic element, a charge transfer layer and a counter electrode, said photovoltaic element comprising a conductive support and a light-sensitive layer containing semiconductor particles spectrally sensitized with a methine dye, wherein the methine dye has a phosphoric group of the formula (P) as a substituent group.

The present inventors have found that adsorption of a cyanine or merocyanine dye on a surface of semiconductor particles can be remarkably improved by introducing into the cyanine or merocyanine dye a phosphoric group as a group. The cyanine or merocyanine dye having the phosphoric substituent group can be easily synthesized in a similar manner to the synthesis of a photographic cyanine or merocyanine dye (only by combining a phosphoric group to a starting compound in the synthesis of the photographic methine dye). Now, a sufficient amount of an inexpensive and excellent cyanine or merocyanine dye can be adsorbed on the surface of semiconductor particles.

The semiconductor particles are sufficiently sensitized by improving the adsorption of the cyanine or merocyanine dye on the surface of the particles. A photovoltaic effect of a photovoltaic element is improved by using the sufficiently sensitized semiconductor particles. As a result, an inexpensive and excellent photovoltaic element or photo-electrochemical cell can be obtained by using the semiconductor particles of the present invention.

<u>BRIEF DESCRIPTION OF THE DRAWING</u>

The figure schematically illustrates a photo-electrochemical cell.

<u>DETAILED DESCRIPTION OF THE INVENTION</u>

[Methine dye]

The cyanine or merocyanine dye used in the present invention has a phosphoric group of the formula (P) as a substituent group.

(P)

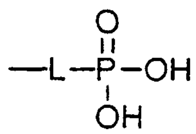

In the formula (P), L is a single bond, -O-, -S- or -NH-. The single bond, -O- and -NH- are preferred, the single bond and -O- are more preferred, and the single bond (namely, the phosphorus atom is directly attached to the methine dye) is most preferred.

In the formula (P), one or both (preferably one) of the hydrogen atoms may be dissociated from the oxygen atoms.

Examples of the phosphoric groups are shown below.

(P1)

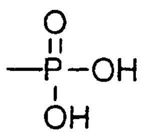

(P2)

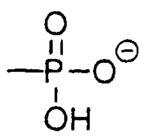

(P3)

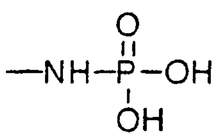

(P4)

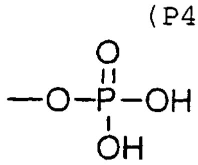

(P5)

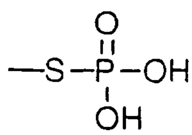

The cyanine or merocyanine dye has a molecular structure consisting of a methine chain and two nuclei (basic, acidic or aromatic nuclei) attached to both ends of the chain. The phosphoric group (P) preferably is a substituent group of the nuclei, more preferably is a substituent group attached to carbon atom contained in the nuclei, and most preferably is a substituent group attached to carbon atom of benzene ring contained in the nuclei. The cyanine or merocyanine dye preferably has 1 to 6 phosphoric groups (P), more preferably has 1 to 4 phosphoric groups, and most preferably has 1 or 2 phosphoric groups.

Dyes having a phosphoric group as a substituent group of nuclei are shown below as the cyanine dye of the formula (I) and the merocyanine dye of the formula (II)

(I) B=Lo-Bo

in which B is a basic nucleus; Bo is an onium form of a basic nucleus; Lo is a methine chain having an odd number of methines; and at least one of B and Bo has the phosphoric group of the formula (P) as a substituent group.

(II) B=Le=A

in which B is a basic nucleus; A is an acidic nucleus of a keto type; Le is a methine chain having an even number of methines; and at least one of B and A has the phosphoric group of the formula (P) as a substituent group.

The cyanine dye of the formula (I) is particularly preferred. In the cyanine dye of the formula (I), each of B and Bo preferably has one (total two) phosphoric group of the formula (P) as a substituent group. In the merocyanine dye of the formula (II), only A preferably has one phosphoric group of the formula (P) as a substituent group.

The cyanine dye and the merocyanine dye are described below in more detail.

In the formulas (I) and (II), B is a basic nucleus. Preferred basic nuclei are shown in the following formulas.

(B-I)

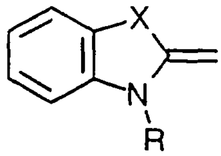

(B-II)

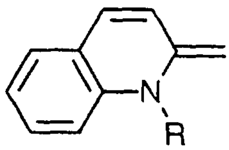

(B-III)

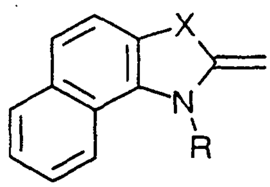

(B-IV)

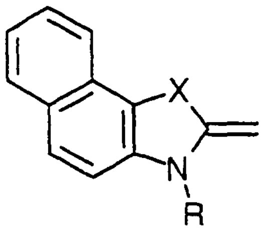

(B-V)

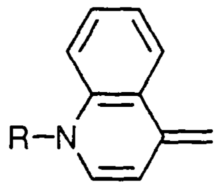

in which X is $-CR_2-$, -NR-, -O-, -S-, -Se- or -Te-(preferably $-CR_2-$, -NR-, -O- or -S-); and R is an alkyl group or an aryl group (preferably an alkyl group). Two or more groups of R may be different from each other.

The alkyl group preferably has a chain structure rather than a cyclic structure. The alkyl group of a chain structure may be branched. The alkyl group preferably has 1 to 20 carbon atom, more preferably has 1 to 15 carbon atoms, further preferably has 1 to 10 carbon atoms, and most preferably has 1 to 6 carbon atoms. Examples of the alkyl groups include methyl, ethyl, n-propyl, n-butyl, n-pentyl, n-hexyl, n-heptyl, n-nonyl, isopropyl, isobutyl, isopentyl and t-butyl. The alkyl group may have a substituent group. Examples of the substituent groups of the alkyl group include an alkylthio group (e.g., methylthio, ethylthio), an arylthio group (e.g., phenylthio), a halogen atom (chlorine, bromine, iodine, fluorine), nitro, an alkoxy group (e.g., methoxy, ethoxy), an aryl group (e.g., phenyl), an aryloxy group (e.g., phenoxy), an amido group, carbamoyl, sulfo, hydroxyl, carboxyl, cyano and the phosphoric group of the formula (P).

The aryl group preferably has 6 to 20 carbon atoms, more preferably has 6 to 15 carbon atoms, and most preferably has 6 to 10 carbon atoms. Examples of the aryl groups include phenyl, 1-naphthyl and 2-naphthyl. The aryl group may have a substituent group. Example of the substituent groups of the aryl group include an alkyl group (e.g., methyl ethyl), an alkylthio group (e.g., methylthio, ethylthio), an arylthio group (e.g., phenylthio), a halogen atom (chlorine, bromine, iodine, fluorine), nitro, an alkoxy group (e.g., methoxy, ethoxy), an aryl group (e.g., phenyl), an aryloxy group (e.g., phenoxy), an amido group, carbamoyl, sulfo, hydroxyl, carboxyl, cyano and the phosphoric group of the formula (P).

The basic nucleus may have a substituent group other than the group of R. Examples of the substituent groups of the basic nucleus include an alkyl group (e.g., methyl ethyl), an alkylthio group (e.g., methylthio, ethylthio), an arylthio group (e.g., phenylthio), a halogen atom (chlorine, bromine, iodine, fluorine), nitro, an alkoxy group (e.g., methoxy, ethoxy), an aryl group (e.g., phenyl), an aryloxy group (e.g., phenoxy), an amido group, carbamoyl, sulfo, hydroxyl, carboxyl, cyano and the phosphoric group of the formula (P).

In the cyanine dye of the formula (I), the phosphoric group of the formula (P) is preferably attached to the basic nucleus, and most preferably attached to the benzene ring of the basic nucleus.

Examples of the basic nuclei are shown below. In the following examples, the number of (P) means the above-described examples of the phosphoric groups.

(B01)

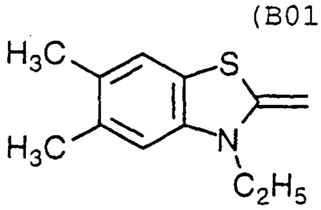

(B02)

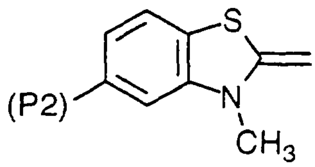

(B03)

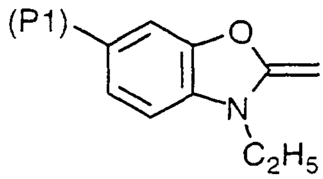

(B04)

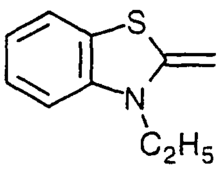

(B05)

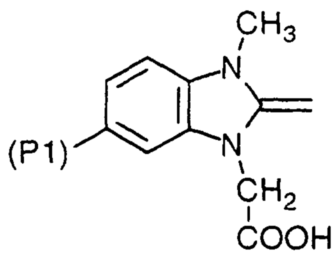

(B06)

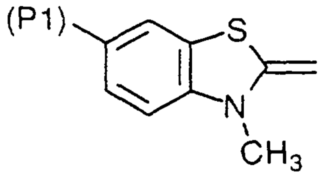

(B07)

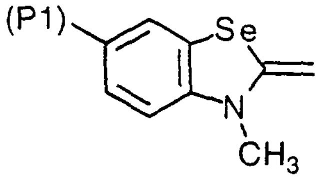

(B08)

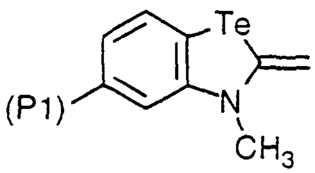

(B09)

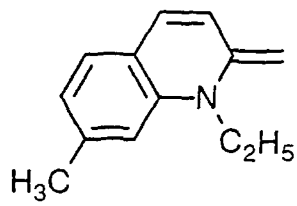

(B10)

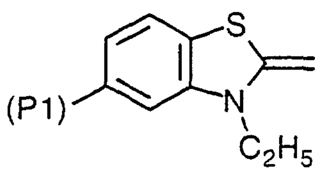

(B11)

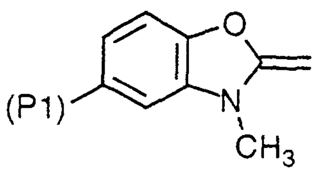

(B12)

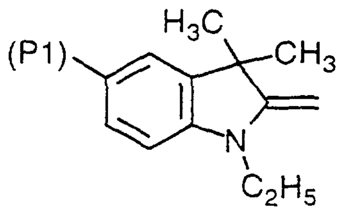

(B13)

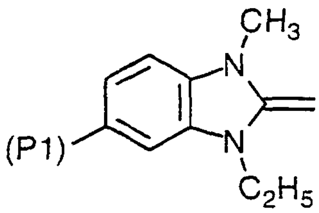

(B14)

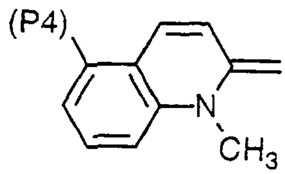

(B15)

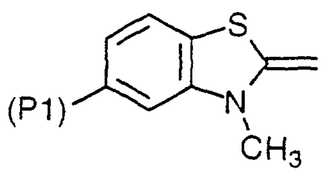

(B16)

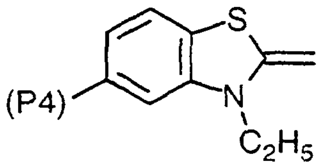

(B17)

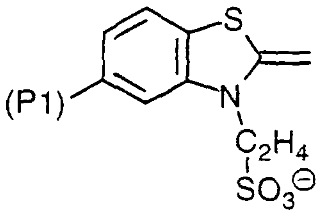

(B18)

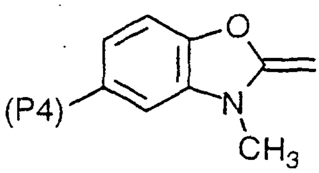

(B19)

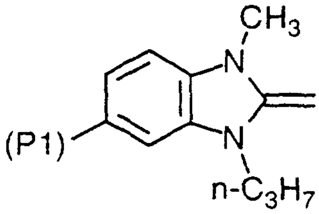

(B20)

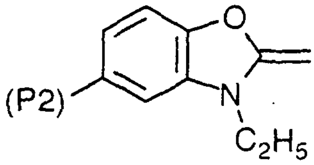

(B21)

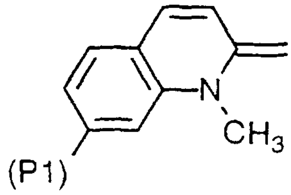

(B22)

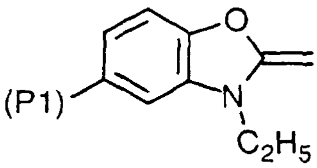

(B23)

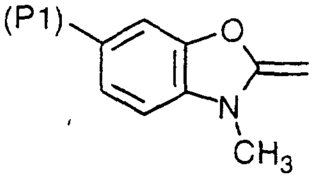

(B24)

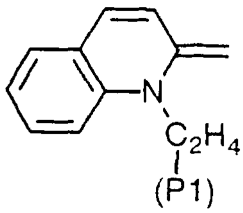

(B25)

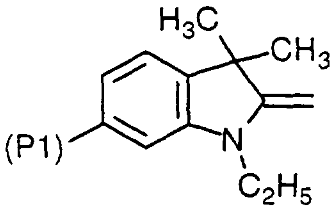

(B26)

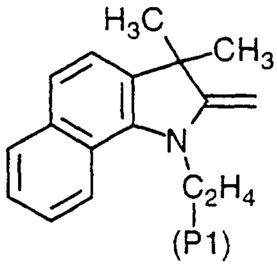

(B27)

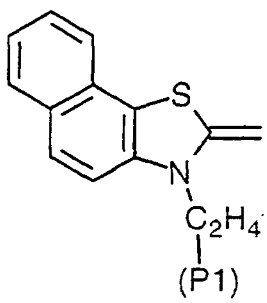

(B28)

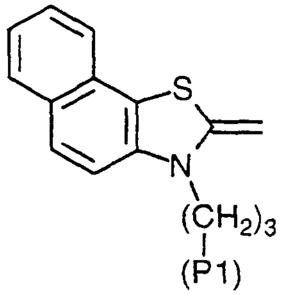

(B29)

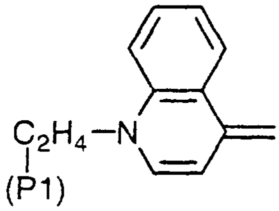

(B30)

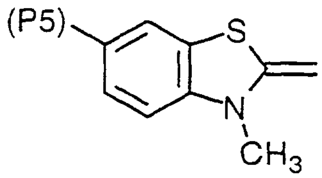

In the formulas (I), Bo is an onium form of a basic nucleus. Preferred onium forms of the basic nuclei are shown in the following formulas.

(Bo-I)

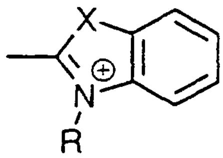

(Bo-II)

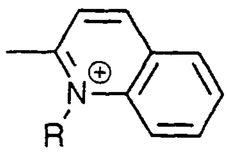

(Bo-III)

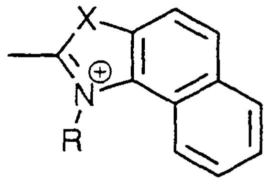

(Bo-IV)

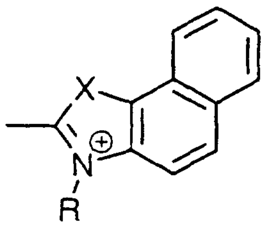

(Bo-V)

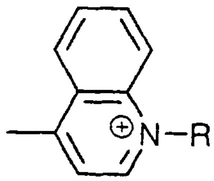

in which X is $-CR_2-$, -NR-, -O-, -S-, -Se- or -Te-(preferably $-CR_2-$, -NR-, -O- or -S-); and R is an alkyl group or an aryl group (preferably an alkyl group). Two or more groups of R may be different from each other.

The definitions and the examples of the alkyl group and the aryl group are the same as those of the alkyl group and the aryl group described about the basic nucleus (B).

The onium form of the basic nucleus (Bo) may have a substituent group other than the group of R. The definitions and the examples of the substituent groups of the onium form are the same as those of the substituent groups of the basic nucleus (B).

In the cyanine dye of the formula (I), the phosphoric group of the formula (P) is preferably attached to the basic nucleus, and most preferably attached to the benzene ring of the onium form of the basic nucleus.

Examples of the onium forms of the basic nuclei are shown below. In the following examples, the number of (P) means the above-described examples of the phosphoric groups.

(Bo01)

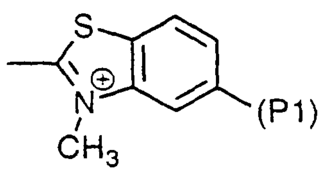

(Bo02)

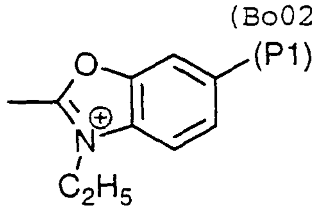

(Bo03)

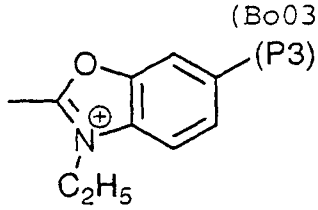

(Bo04)

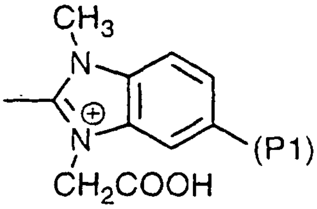

(Bo05)

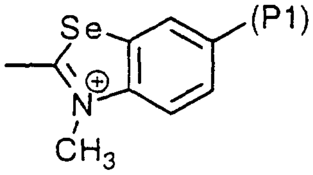

(Bo06)

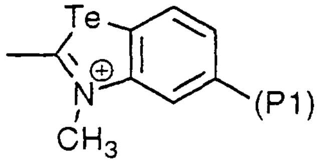

(Bo07)

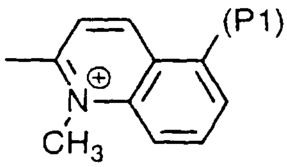

(Bo08)

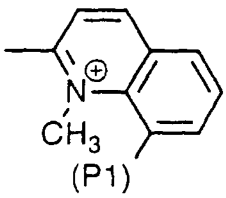

(Bo09)

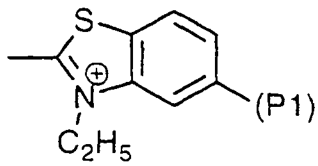

(Bo10)

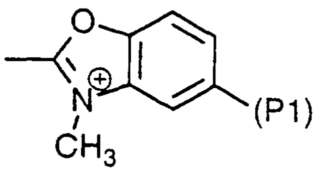

(Bo11)

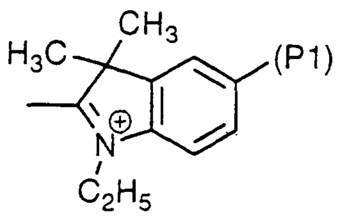

(Bo12)

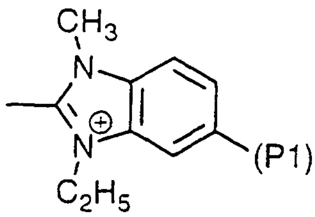

(Bo13)

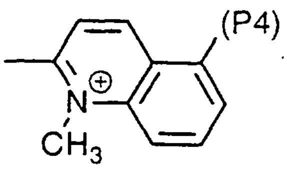

(Bo14)

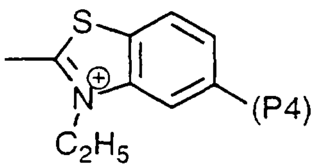

(Bo15)

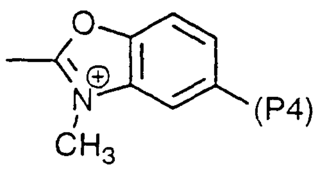

(Bo16)

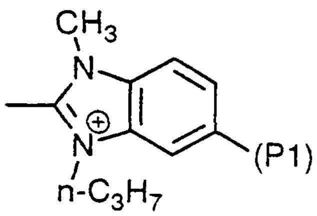

(Bo17)

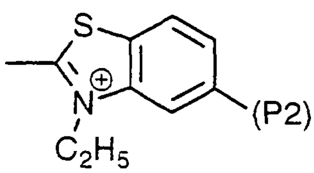

(Bo18)

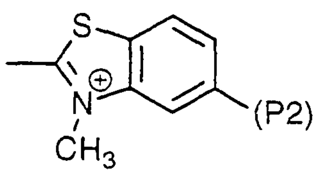

(Bo19)

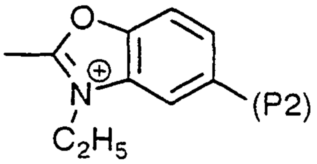

(Bo20)

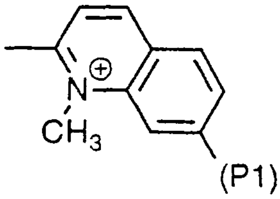

(Bo21)

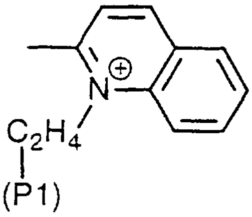

(Bo22)

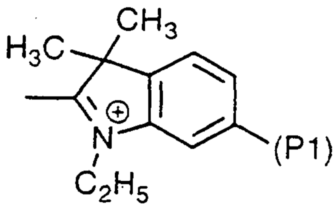

(Bo23)

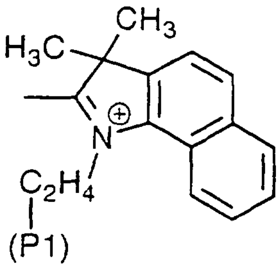

(Bo24)

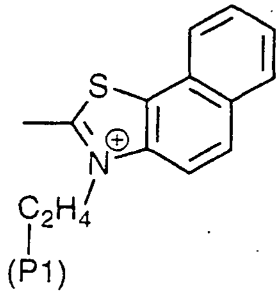

(Bo25)

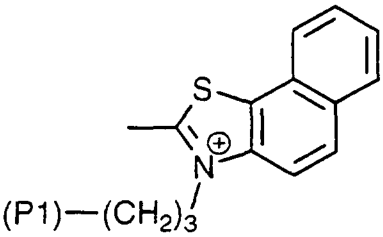

(Bo26)

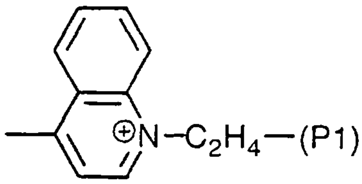

In the formulas (II), A is an acidic nucleus of a keto type. Preferred acidic nuclei of a keto type are shown in the following formulas.

(A-I)

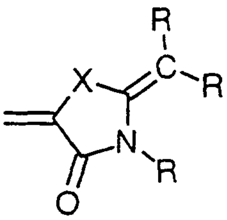

(A-II)

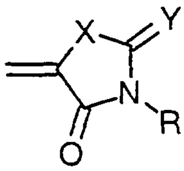

(A-III)

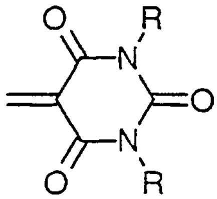

in which X is -NR-, -O-, -S-, -Se- or -Te- (preferably -NR-, -O- or -S-); Y is =O or =S (preferably =S); R is hydrogen, an alkyl group, an alkenyl group, an aryl group or cyano. Two or more groups of R may be different from each other.

The definitions and the examples of the alkyl group and the aryl group are the same as those of the alkyl group and the aryl group described about the basic nucleus (B).

The alkenyl group preferably has a chain structure rather than a cyclic structure. The alkenyl group of a chain structure may be branched. The alkenyl group preferably has 2 to 20 carbon atom, more preferably has 2 to 15 carbon

atoms, further preferably has 2 to 10 carbon atoms, and most preferably has 2 to 6 carbon atoms. The alkenyl group may have a substituent group. Examples of the substituent groups of the alkenyl group include an alkylthio group (e.g., methylthio, ethylthio), an arylthio group (e.g., phenylthio), a halogen atom (chlorine, bromine, iodine, fluorine), nitro, an alkoxy group (e.g., methoxy, ethoxy), a heterocyclic group, an aryl group (e.g., phenyl), an aryloxy group (e.g., phenoxy), an amido group, carbamoyl, sulfo, hydroxyl, carboxyl, cyano and the phosphoric group of the formula (P).

The acidic nucleus of a keto type (A) may have a substituent group other than the group of R. The definitions and the examples of the substituent groups of the onium form are the same as those of the substituent groups of the basic nucleus (B).

In the merocyanine dye of the formula (II), the phosphoric group of the formula (P) is preferably attached to the acidic nucleus of the keto type, and most preferably is a substituent group of R (an alkyl group, an alkenyl group or an aryl group) of the acidic nucleus of the keto type.

Examples of the acidic nuclei of the keto type are shown below. In the following examples, the number of (P) means the above-described examples of the phosphoric groups.

(A1)

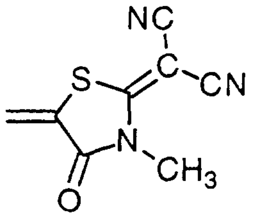

(A2)

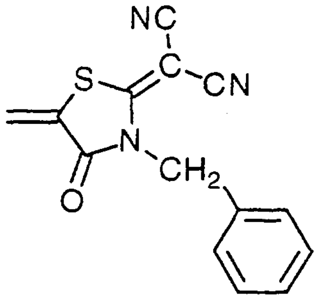

(A3)

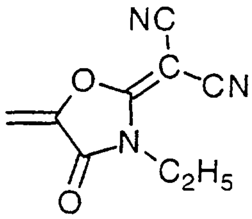

(A4)

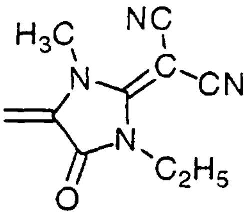

(A5)

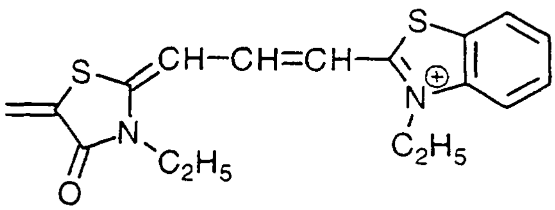

(A6)

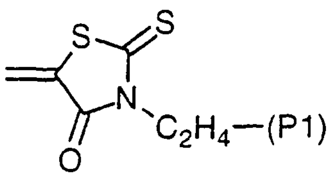

(A7)

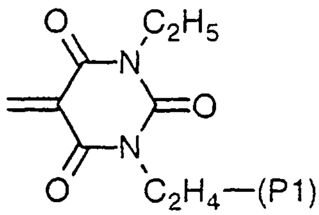

In the formula (I), Lo is a methine chain having an odd number of methines. The number of the methines preferably is 1, 3, 5, 7 or 9, more preferably is 1, 3, 5 or 7, and most preferably is 3, 5 or 7.

The methine chain may have a substituent group. The substituent group preferably is an alkyl group having 1 to 6 carbon atoms (e.g., methyl, ethyl).

Two or more substituent groups of the methine chain may be combined to form an unsaturated aliphatic ring (e.g., cyclopentene ring, cyclohexene ring, isophorone ring, squarilium ring, croconium ring). Where the methine chain has only one substituent group, the sole substituent group is preferably attached to the centered (meso-positioned) methine.

Examples of the methine chains having an odd number of methines are shown below.

(Lo01)

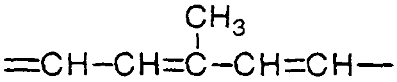

(Lo02)

=CH−CH=CH−CH=CH—

(Lo03)

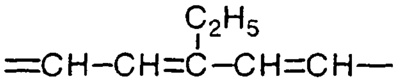

(Lo04)

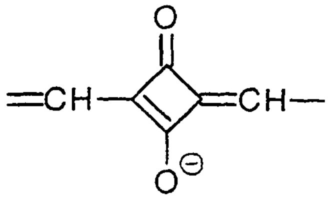

(Lo05)

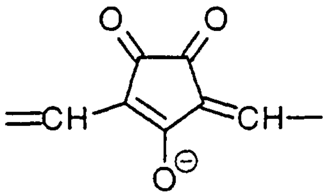

(Lo06)

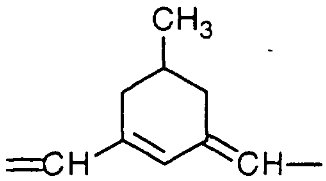

(Lo07)

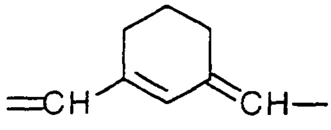

(Lo08)

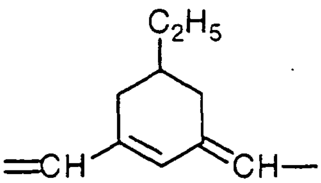

(Lo09)

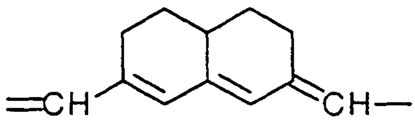

(Lo10)

=CH−CH=CH−CH=CH−CH=CH−CH=CH—

(Lo11)

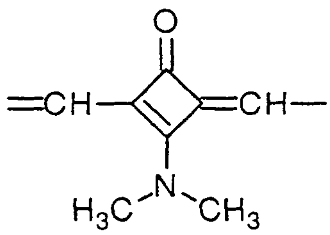

In the formula (II), Le is a methine chain having an even number of methines. The number of the methines preferably is 2, 4, 6 or 8, more preferably is 2, 4 or 6, and most preferably is 2 or 4.

The methine chain may have a substituent group. The substituent group preferably is an alkyl group having 1 to 6 carbon atoms (e.g., methyl, ethyl).

Examples of the methine chains having an even number of methines are shown below.

$=CH-CH=CH-CH=$ (Le1)

$=CH-CH=$ (Le2)

The cyanine dye and the merocyanine dye comprise the combination of the above-mentioned basic nucleus (B), onium form of the basic nucleus (Bo), acidic nucleus (A) and methine chain (Lo or Le). There are no specific limitations about the combination. In view of synthesis of the cyanine dye, the chemical structure of the basic nucleus (B) preferably corresponds to the structure of the onium form of the basic nucleus (Bo).

The dye can have a charge balance ion. The kind (cation or anion) and number of the charge balance ion depend on the kind and number of an ionic substituent group of the methine dye.

Examples of the charge balance cations include an alkali metal ion (e.g., sodium ion, potassium ion) and an ammonium ion (e.g., triethylammonium ion, pyridinium ion, 1-ethylpyridinium ion).

Examples of the charge balance anions include a halide ion (e.g., chloride ion, bromide ion, fluoride ion, iodide ion), an arylsulfonate ion (e.g., p-toluenesulfonate ion), an alkylsulfate ion (e.g., methylsulfate ion), sulfate ion, perchlorate ion, tetrafluoroborate ion and acetate ion.

Examples of dyes having a phosphoric substituent group are shown below. In the following examples, the numbers of B, Bo, A, Lo and Le correspond to the examples of the basic nucleus, the onium form of the basic nucleus, the acidic nucleus of the keto type, the methine chain having an odd number of methines, and the methine chain having an even number of methines respectively.

| No. | Basic nucleus=Methine-Onium form•Charge balance ion | | |
|---|---|---|---|
| I-1 | B01=Lo01-Bo01•$I^-$ | I-2 | B02=Lo02-Bo01 |
| I-3 | B03=Lo02-Bo02•$Cl^-$ | I-4 | B04=LoO1-BoO3•$Cl^-$ |
| I-5 | B05=LoO2-BoO4•$ClO_4^-$ | I-6 | B06=Lo02-Bo04•$ClO_4^-$ |
| I-7 | B07=Lo01-Bo05•$ClO_4^-$ | I-8 | B08=Lo02-Bo06-$ClO_4^-$ |
| I-9 | B09=Lo03-Bo07-$ClO_4^-$ | I-10 | B06=Lo01-Bo08•$ClO_4^-$ |
| I-11 | B10=Lo04-Bo09 | I-12 | B11=Lo04-Bo10 |
| I-13 | B12=Lo04-Bo11 | I-14 | B13=Lo04-Bo12 |
| I-15 | B14=Lo04-Bo13 | I-16 | B10=Lo05-Bo09 |
| I-17 | B11=Lo05-Bo10 | I-18 | B12=Lo05-Bo11 |
| I-19 | B13=Lo05-Bo12 | I-20 | B14=Lo05-Bo13 |
| I-21 | B15=Lo06-Bo01•$I^-$ | I-22 | B16=Lo07-Bo14•$Cl^-$ |
| I-23 | B17=Lo08-Bo10 | I-24 | B18=Lo06-Bo15•$Cl^-$ |
| I-25 | B19=LoO7-Bo16•$Cl^-$ | I-26 | B15=Lo09-Bo01•$I^-$ |
| I-27 | B10=Lo09-Bo17 | I-28 | B02=Lo09-Bo18•$Na^+$ |
| I-29 | B20=LoO9-Bo19•$K^+$ | I-30 | B21=Lo09-Bo20•$I^-$ |
| I-31 | B15=Lo10-Bo09•$Cl^-$ | I-32 | B24=Lo04-Bo21 |
| I-33 | B25=Lo04-Bo22 | I-34 | B26=Lo04-Bo23 |
| I-35 | B28=Lo04-Bo25 | I-36 | B26=Lo11-Bo23•$I^-$ |
| I-37 | B27=Lo11-Bo24•$I^-$ | I-38 | B10=Lo05-Bo09 |
| I-39 | B25=Lo05-Bo22 | I-40 | B26=Lo05-Bo23 |
| I-41 | B29=Lo04-Bo26 | I-42 | B30=Lo04-Bo26 |

| No. | Basic nucleus=Methine=Acidic nucleus•Charge balance ion | |
|---|---|---|
| II-1 | B10=Le1=A1 | II-2 B15=Le1=A2 |
| II-3 | B22=Le1=A2 | II-4 B23=Le1=A3 |
| II-5 | B13=Le1=A4 | II-6 B15=Le1=A5•$Cl^-$ |
| II-7 | B04=Le2=A6 | II-8 B04=Le2=A7 |

The dye can has a specific molecular structure in which the methine chain is fused with the nuclei. Examples of dyes having the specific molecular structure and the phosphoric substituent group (classified as cyanine dyes) are

shown below.

I-43

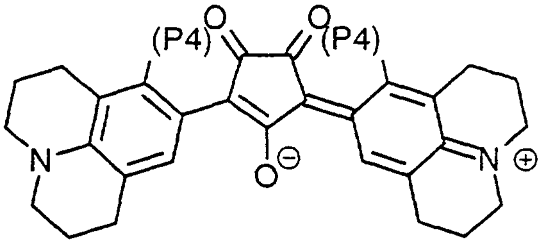

I-44

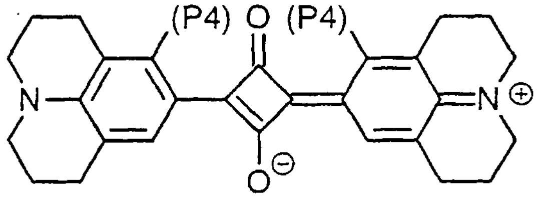

The dyes are described in F.M. Harmer, Heterocyclic Compounds-Cyanine Dyes and Related Compounds, John Wiley & Sons, New York, London (1964), and D.M. Sturmer, Heterocyclic Compounds-Special topics in heterocyclic chemistry, volume 18, section 14, pages 482 to 515, John Wiley & Sons, New York, London (1977).

The synthesis methods of the dyes are described in the above-mentioned publications as well as Rodd's Chemistry of Carbon Compounds, second edition, volume IV, part B (1977), chapter 15, pages 368 to 422, Elsevier Science Publishing Company Inc. New York, and British Patent No. 1,077,611.

Synthesis examples of the dye having the phosphoric substituent group are shown below. The other dyes can be synthesized in a similar manner by referring to the above-mentioned publications.

SYNTHESIS EXAMPLE 1

(Synthesis of dye I-1)

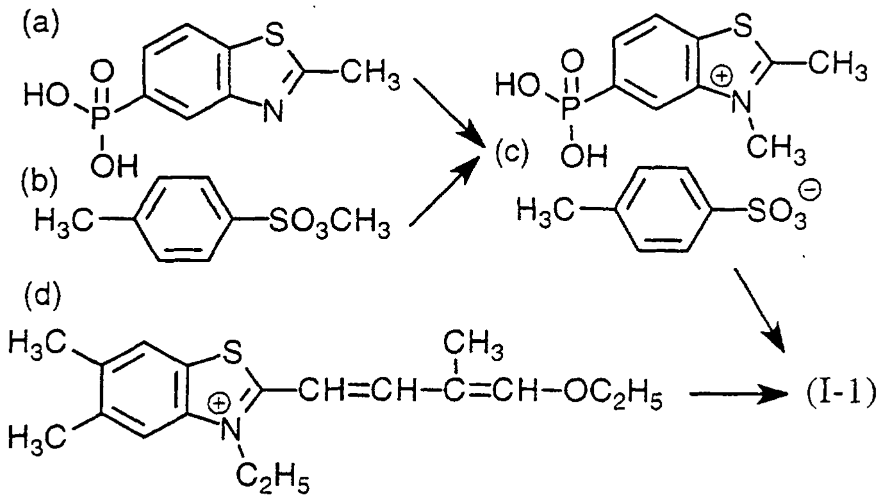


A mixture of 0.50 g of the compound (a) and 0.36 ml of methyl p-toluenesulfonate was heated at 160°C for 5 hours. To the obtained brown syrupy substance (c), 0.75 g of the compound (d), 10 ml of acetonitrile, 5 ml of water and 0.73 ml of triethylamine were added. The mixture was refluxed for 10 minutes while heating. The mixture was further stirred at the room temperature for 1 hour. The obtained crystals were filtered off with suction, and recrystallized with a mixture of methanol and acetonitrile to obtain 0.40 g of the dye I-1. The λmax was 654 nm ($\varepsilon = 2.0 \times 10^5$ in methanol).

SYNTHESIS EXAMPLE 2

(Synthesis of dye I-2)

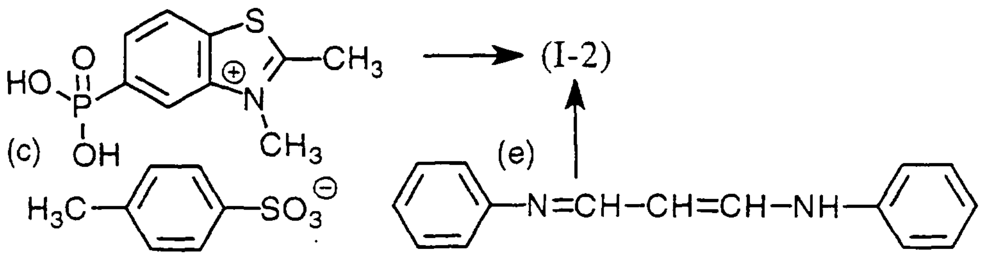

To the brown syrupy substance (c) obtained in the Synthesis Example 1, 0.18 g of the compound (e), 10 ml of acetonitrile, 0.25 ml of triethylamine and 0.16 g of acetic anhydride were added. The mixture was refluxed for 30 minutes while heating. The mixture was further stirred at the room temperature for 30 minutes. The obtained crystals were filtered off with suction, and recrystallized with a mixture of methanol and acetonitrile to obtain 0.20 g of the dye I-2. The λmax was 655 nm (ε = $1.9 \times 10^5$ in methanol).

SYNTHESIS EXAMPLE 3

(Synthesis of dye I-11)

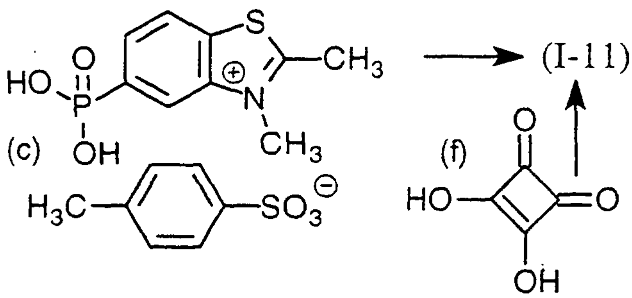

To 2.20 g of the brown syrupy substance (c) obtained in the Synthesis Example 1, 0.29 g of the compound (f), 15 ml of butanol and 15 ml of toluene were added. The mixture was refluxed for 2 hours while dehydrating. After the mixture was cooled, ethyl acetate was added to the mixture to obtain crystals. The obtained crystals were filtered off with suction, and recrystallized with a mixture of methanol and acetonitrile to obtain 1.20 g of the dye I-11. The λmax was 646 nm (ε = $2.9 \times 10^5$ in methanol).

SYNTHESIS EXAMPLE 4

(Synthesis of dye I-34)

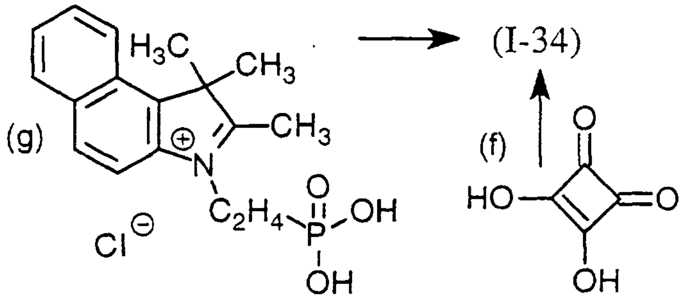

(g) (f) (I-34)

To 1.0 g of the compound (g), 0.16 g of the compound (f), 12 ml of butanol and 4 ml of toluene were added. The mixture was refluxed for 3 hours while dehydrating. After the mixture was cooled, ethyl acetate was added to the mixture to obtain crystals. The obtained crystals were filtered off with suction, and recrystallized with a mixture of methanol and acetonitrile to obtain 0.5 g of the dye I-34. The $\lambda$max was 660 nm ($\varepsilon = 2.9 \times 10^5$ in methanol).

[Semiconductor particle]

The semiconductor used in the particle has a specific resistance in the range of $10^{-2}$ to $10^9$ $\Omega$•cm at ordinary temperature based on conduction electron or positive hole. The simply measured value of the specific resistance is preferably in the range of $10^{-2}$ to $10^5$ $\Omega$•cm. The semiconductor preferably is a metal chalcogenide (e.g., oxide, sulfide, selenide) or a perovskite (e.g., strontium titanate, calcium titanate). The metal used as the metal oxide preferably is titanium, tin, zinc, tungsten, zirconium, hafnium, strontium, indium, cerium, yttrium, lanthanum, vanadium, niobium or tantalum. The metal used as the metal sulfide or selenide preferably is cadmium. Titanium dioxide, zinc oxide, tin dioxide and tungsten oxide are particularly preferred.

The semiconductor particles preferably have a large surface area to adsorb a large amount of the cyanine or merocyanine dye.

The semiconductor particles preferably have a small particle size to obtain the large surface area. The particle size is preferably in the range of 5 to 200 nm, and more preferably in the range of 8 to 100 nm.

The semiconductor particles also preferably have a shape of a rough surface to obtain the large surface area. The ratio of the surface area to the projected area (i.e., roughness factor described in U.S. Patent No. 4,927,721) is preferably more than 10, and more preferably more than 100. The particles having the large surface area can be prepared, for example by aggregation of fine semiconductor particles to form secondary particles.

A cyanine or merocyanine dye can be adsorbed on semiconductor particles by immersing well-dried particles in a solution of the cyanine or merocyanine dye. The solution of the cyanine or merocyanine dye can be heated at 50 to 100°C.

In the preparation of a photovoltaic element (described below), the cyanine or merocyanine dye can be adsorbed on the semiconductor particles after coating the particles (forming a light-sensitive layer). Further, the cyanine or merocyanine dye can be adsorbed on the semiconductor particles by coatting the dye and the particles simultaneously. Not adsorbed cyanine or merocyanine dye is removed by washing. Where the light-sensitive layer is formed by burning, the adsorption of the cyanine or merocyanine dye is preferably conducted after burning. The adsorption is more preferably conducted immediately after burning before the surface of the light-sensitive layer adsorbs water (or absorbs moisture).

Two or more cyanine or merocyanine dyes can be used in combination at the adsorption process. The cyanine or merocyanine dye having a phosphoric substituent group can be used in combination with a methine dye. The methine dye can also be used in combination with a complex dye (described in U.S. Patent Nos. 4,684,537, 5,084,365, 5,350644, 5,463,057, 5,525,440 and Japanese Patent Provisional Publication No. 7(1995)-249790). Where the semiconductor particles are used in a photo-electrochemical cell, two or more dyes are preferably used in combination to obtain a broad wavelength region of the photovoltaic effect.

In the case that two or more dyes are used in combination, an interaction between the dyes such as association is reported. A colorless substance can be further adsorbed on the semiconductor particles to reduce the interaction. The colorless substance preferably is hydrophobic. The colorless hydrophobic substance preferably is a steroid compound having carboxyl (e.g., cholic acid).

The amount of the adsorbed cyanine or merocyanine dye on the semiconductor particles is preferably in the range of 0.01 to 100 mmol per $m^2$, more preferably in the range of 0.1 to 50 mmol per $m^2$, and most preferably in the range of 0.5 to 20 mmol per $m^2$ in terms of the coated amount of the cyanine or merocyanine dye.

After the adsorption of the cyanine or merocyanine dye, the surface of the semiconductor particles can be treated with an amine. Examples of the amines include pyridine, 4-t-butylpyridine and polyvinyl pyridine. Where the amine is liquid, the semiconductor particles adsorbing the methine dye are immersed in the liquid amine to conduct the surface treatment. Where the amine is solid, the amine is dissolved in an organic solvent to obtain a solution, and the semiconductor particles adsorbing the cyanine or merocyanine dye are immersed in the solution of the amine to conduct the surface treatment.

[Photovoltaic element]

The photovoltaic element is an electrode comprising a conductive support and a light-sensitive layer containing semiconductor particles spectrally sensitized with a cyanine or merocyanine dye. Two or more light-sensitive layers can be provided on the conductive support. Two or more cyanine or merocyanine dyes or two or more semiconductor particles can be contained in one light-sensitive layer.

The conductive support of the photovoltaic element is made of a conductive material such as a metal plate, or is made by forming a conductive layer on an insulating material such as a glass plate or a plastic film. The conductive layer can be formed by using a metal (e.g., platinum, gold, silver, copper, aluminum, rhodium, indium), carbon or a conductive metal oxide (e.g., indium-tin complex oxide, fluorine doped tin oxide).

The surface resistance of the conductive support is preferably not larger than 50 Ω per $cm^2$, and more preferably not larger than 10 Ω per $cm^2$.

The conductive support preferably is transparent. The light transmittance is preferably not less than 10%, more preferably not less than 50%, and most preferably not less than 80%. A conductive layer containing a conductive metal oxide is preferably formed on a glass plate or a plastic film to obtains a transparent conductive support. Where the transparent conductive support is used, light preferably incidents on the side of the support.

A light-sensitive layer containing semiconductor particles can be formed by coating a dispersion or a colloidal solution of the semiconductor particle on the conductive support. A light-sensitive layer containing semiconductor particles can also be formed by coating a precursor of the semiconductor particles (e.g., titanium tetraisopropoxide, titanium tetrabutoxide, titanium tetrachloride) on the conductive support, and hydrolyzing the precursor by a moisture in the air. A dispersion of the semiconductor particles can be prepared by grinding a semiconductor in a mortar or a mill. A dispersion of the semiconductor particles can also be obtained by precipitating the semiconductor particles in a process of synthesizing the semiconductor. Water or an organic solvent (e.g., methanol, ethanol, dichloromethane, acetone, acetonitrile, ethyl acetate) can be used as a dispersing medium. A dispersing aid such as a polymer, a surface active agent, an acid or a chelating agent can be used in the dispersing process.

If a light-sensitive layer containing semiconductor particles is thick, the amount of the dye per area is increased to improve light absorption efficiency. On the other hand, the diffusion length of electron is increased with the increase of the thickness of the layer to further increase the charge recombination loss. The light-sensitive layer containing semiconductor particles usually has a thickness in the range of 0.1 to 100 μm. In a photo-electrochemical cell, the light-sensitive layer has a thickness preferably in the range of 1 to 50 μm, and more preferably in the range of 3 to 30 μm.

After the light-sensitive layer is formed on the conductive support, the layer can be subjected to a burning treatment to adhere the semiconductor particles with each other. As is described above, the absorption of the dye on the semiconductor particles is preferably conducted after the burning treatment.

[Photo-electrochemical cell]

The photovoltaic element can be used in various sensors or photo-electrochemical cells. The semiconductor particles sensitized with the dye according to the present invention are particularly effective in a photo-electrochemical cell.

The figure schematically illustrates a photo-electrochemical cell.

As is shown in figure, the photo-electrochemical cell comprises a photovoltaic element (1), a charge transfer layer (2) and a counter electrode (3). The photovoltaic element (1) functions as a negative electrode of the photo-electrochemical cell. The photovoltaic element (1) comprises a conductive support (11) and a light-sensitive layer (12). The light-sensitive layer (12) contains semiconductor particles (122) having a surface on which a methine dye (121) is adsorbed.

Light (4) incidents on the light-sensitive layer (12) through the transparent conductive support (11). Light excites the methine dye (121). The excited methine dye has an electron (e) of a high energy. The electron (e) is transferred from the methine dye (121) to a conductive band formed by semiconductor particles (122) in the light-sensitive layer. The electron (e) was further diffused to the conductive support (12). After the electron (e) was removed, the molecule of the methine dye (121) is changed to an oxidation product. The electron (e) was further transferred from the photovoltaic element (1), namely the negative electrode to an outer circuit (5). After the electron (e) works in the outer circuit (5), the electron (e) is transferred to the counter (positive) electrode (3). The electron (e) is return to the oxidation product of the

methine dye through the charge transfer layer (2).

As is described in the figure, the charge transfer layer has a function of supplying the electron to the oxidation product of the dye.

The charge transfer layer contains an oxidation-reduction pair. The charge transfer layer can be formed by using a solution of the oxidation-reduction pair in an organic solvent, a gel electrolyte in which a polymer matrix is impregnated with the solution of the oxidation-reduction pair or a melting salt containing the oxidation-reduction pair.

Examples of the oxidation-reduction pairs include a combination of iodine and iodide (e.g., lithium iodide, tetrabutylammonium iodide, tetrapropylammonium iodide), a combination of an alkylviologen (e.g., methylviologen chloride, hexylviologen bromide, benzylviologen tetrafluoroborate) and a reduction product thereof, a combination of a polyhydroxybenzene (e.g., hydroquinone, naphthohydroquinone) and an oxidation product thereof, and a combination of a divalent iron complex (e.g., potassium hexacyanoferrate(II)) and a trivalent iron complex (e.g., potassium hexacyanoferrate (III)). The combination of iodine and iodide is particularly preferred.

The organic solvent preferably is a polar but not proton donating solvent (e.g., acetonitrile, propylene carbonate, ethylene carbonate, dimethylformamide, dimethylsulfoxide, sulfolane, 1,3-dimethylimidazoline, 3-methyloxazolidinone). The polymer of the electrolyte matrix preferably is polyacrylonitrile or polyvinylidene fluoride. The melting salt preferably is a mixture of lithium iodide and anther lithium salt (e.g., lithium acetate, lithium perchlorate). A polymer such as polyethylene oxide can be added to the melting salt to add fluidize the salt at room temperature.

The concentration of the oxidation-reduction pair is so adjusted that the pair functions as a carrier of an electron. The total concentration of the oxidation-reduction pair is preferably not less than 0.01 mol per liter, more preferably not less than 0.1 mol per liter, and most preferably not less than 0.3 mol per liter.

As is described in the figure, the counter electrode function as a positive electrode of the photo-electrochemical cell. The counter electrode can be prepared by the materials described about the conductive support of the photovoltaic element.

At least one of the conductive support and the counter electrode should be substantially transparent so that light reaches the light-sensitive layer. In the photo-electrochemical cell, the conductive support is preferably transparent, and light preferably incidents on the side of the support. Where the conductive support is transparent, the counter electrode preferably reflects light. The counter electrode preferably is a glass plate or a plastic film having a surface on which a metal or a conductive metal oxide is evaporated, and particularly preferably is a glass plate having a surface on which platinum is evaporated.

The side of the photo-electrochemical cell is preferably sealed with a polymer or an adhesive to prevent evaporation of the components.

EXAMPLE 1

(Preparation of titanium dioxide dispersion)

In a stainless steel vessel having an inner volume of 200 ml and an inside surface coated with polytetrafluoroethylene, 15 g of titanium dioxide (Degussa P-25, Japan Aerozil Co., Ltd.), 45 g of water, 1 g of a dispersing agent (Triton X-100, Ardorich) and 30 g of zirconia beads (diameter: 0.5 mm, Nikkato) were placed. The mixture was dispersed at 1,500 rpm for 2 hours in a sand grinder mill (Imex). The zirconia beads were removed from the dispersion by filtration. The average particle size of the titanium dioxide particles was 20 nm.

(Preparation of photovoltaic element)

A conductive glass coated with fluorine doped tin oxide (TCO glass of Asahi Glass Co., Ltd. was cut into pieces of 20 mm $\times$ 20 mm) was used as the conductive support. On the conductive layer (tin oxide layer), the titanium dioxide dispersion was coated by a glass bar. An adhesive tape was pasted on a part of the conductive layer (3 mm from the end) to form a spacer. The glass plates were so placed that the adhesive tape was arranged at the end of the plate. The titanium dioxide dispersion was coated on 8 plates simultaneously. After coating, the plates were air dried at room temperature for 1 day. The adhesive tape was removed from the plate. The area to which the tape was attached was used as an electric contacting area at the measurement of the photovoltaic conversion. The glass plate was placed in an electric furnace (muffle furnace, FP-32, Yamato Science Co., Ltd.), and burned at 450°C for 30 minutes. After the glass plate was cooled, the plate was immersed in an ethanol solution ($3\times10^{-4}$ mol per liter) of the dye set forth in Table 1 for 3 hours. The glass plate was further immersed in 10 wt.% ethanol solution of 4-t-butylpyridine for 30 minutes. The plate was washed with ethanol, and dried.

(Preparation of photo-electrochemical cell)

The above-prepared photovoltaic element was laminated with a glass plate having evaporated platinum (counter electrode). The size of the glass plate was the same as the size of the photovoltaic element. An electrolyte was introduced into the gap between the two plates by capillary phenomenon. The electrolyte contains 0.05 mol per liter of iodide and 0.5 mol per liter of lithium iodide in a mixture of acetonitrile and N-methyl-2-oxazolidinone. The volume ratio of the acetonitrile to N-methyl-2-oxazolidinone was 90 to 10.

(Measurement of photovoltaic conversion efficiency)

Light of a xenon lump (Ushio Co., Ltd.) of 500 W passed through a spectral filter (AM 1.5G, Oriel) and a sharp cut filter (Kenko L-42) to form a pseudo sun light containing no ultraviolet. The intensity of light was 100 mW per $cm^2$.

The photo-electrochemical cell was irradiated with the pseudo sun light. The formed electric current was measured by an ampere and volt meter (Caseray 238 type). As a result, an open voltage (V), a short circuit current ($mA/cm^2$), a shape factor and a photovoltaic conversion efficiency (%) were obtained. The results are set forth in Table 1. The shape factor means the ratio of the measured maximum power to the theoretical maximum power (open voltage × short circuit current). Accordingly, the shape factor is defined by the following formula

$$\text{Shape factor} = \text{Maximum power} / (\text{Open voltage} \times \text{Short circuit current})$$

TABLE 1

| Dye | (P) | Open voltage | Short-circuit current density | Shape factor | Photo-voltaic conversion efficiency |
|---|---|---|---|---|---|
| C-1 | - | 0.060 V | 0.05 $mA/cm^2$ | 0.25 | 0.001% |
| C-2 | - | 0.135 V | 0.09 $mA/cm^2$ | 0.36 | 0.004% |
| I-1 | + | 0.405 V | 1.05 $mA/cm^2$ | 0.50 | 0.213% |
| I-2 | + | 0.403 V | 1.10 $mA/cm^2$ | 0.48 | 0.213% |
| I-11 | + | 0.411 V | 1.50 $mA/cm^2$ | 0.50 | 0.308% |
| I-13 | + | 0.425 V | 1.19 $mA/cm^2$ | 0.50 | 0.253% |
| I-16 | + | 0.398 V | 1.05 $mA/cm^2$ | 0.49 | 0.205% |
| I-21 | + | 0.401 V | 1.15 $mA/cm^2$ | 0.49 | 0.226% |
| I-26 | + | 0.468 V | 1.19 $mA/cm^2$ | 0.40 | 0.223% |
| I-33 | + | 0.430 V | 1.55 $mA/cm^2$ | 0.56 | 0.370% |
| I-34 | + | 0.505 V | 3.41 $mA/cm^2$ | 0.34 | 0.649% |
| I-40 | + | 0.505 V | 1.05 $mA/cm^2$ | 0.49 | 0.205% |
| II-1 | + | 0.505 V | 1.08 $mA/cm^2$ | 0.38 | 0.207% |
| II-7 | + | 0.510 V | 1.38 $mA/cm^2$ | 0.50 | 0.352% |
| II-8 | + | 0.505 V | 1.62 $mA/cm^2$ | 0.48 | 0.393% |

(Remark)
(P): A phosphoric substituent group is attached to the dye (+) or not (-).

(C-1)

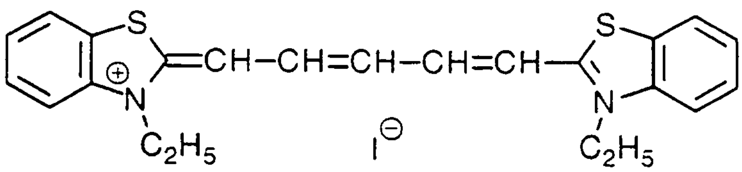

(C-2)

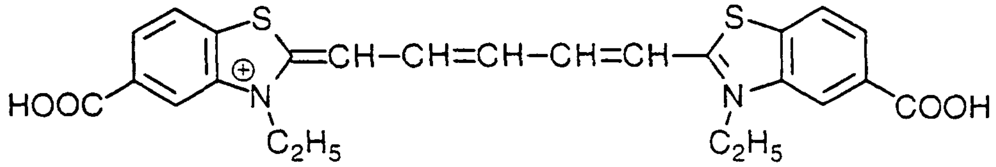

(I-1)

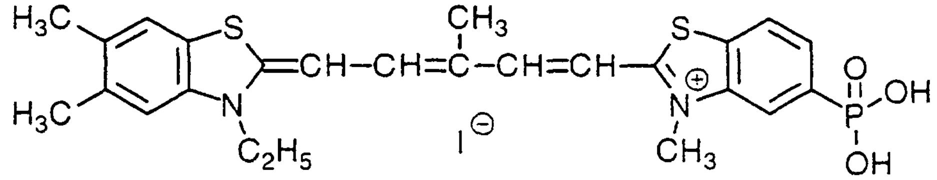

(I-2)

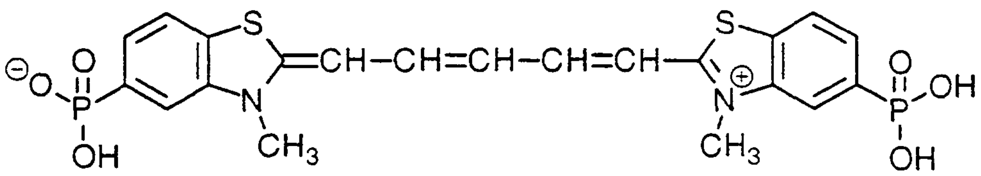

(I-11)

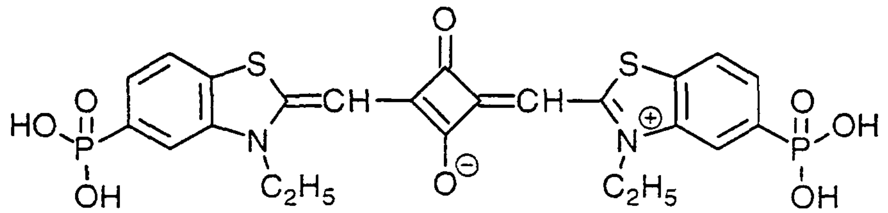

(I-13)

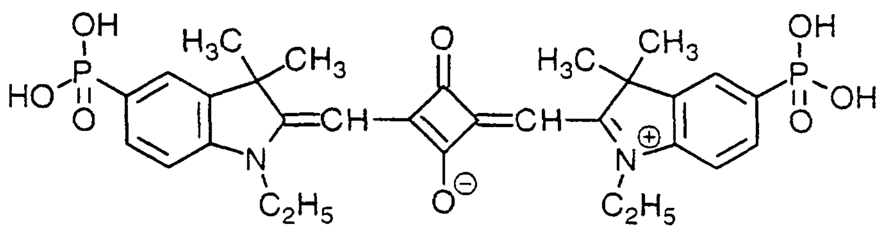

(I-16)

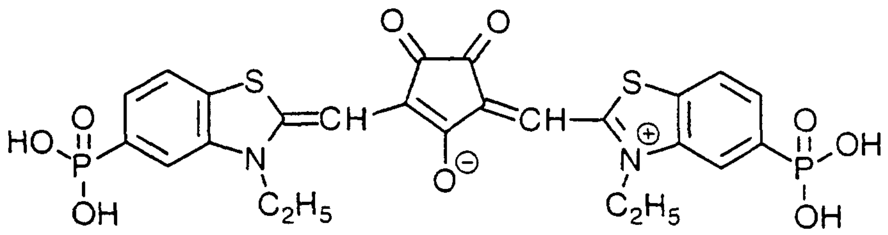

(I-21)

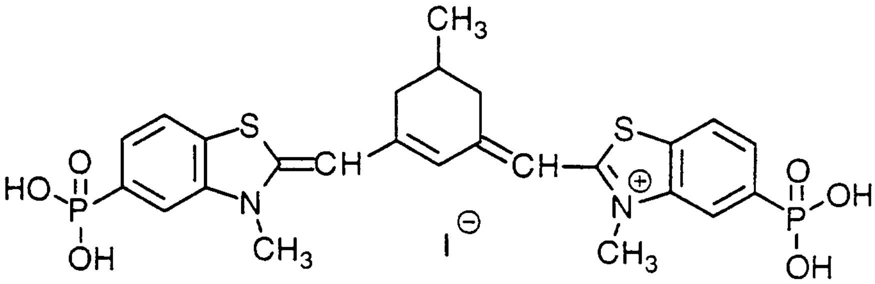

(I-26)

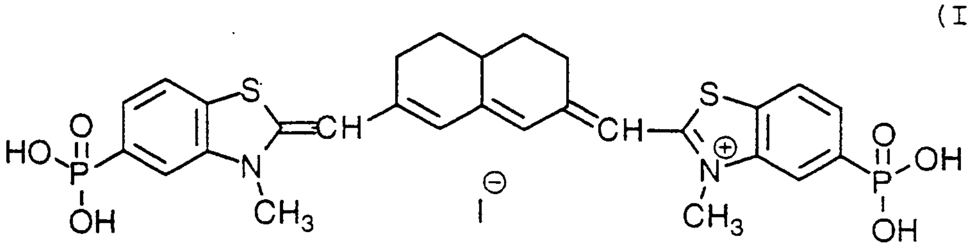

(I-33)

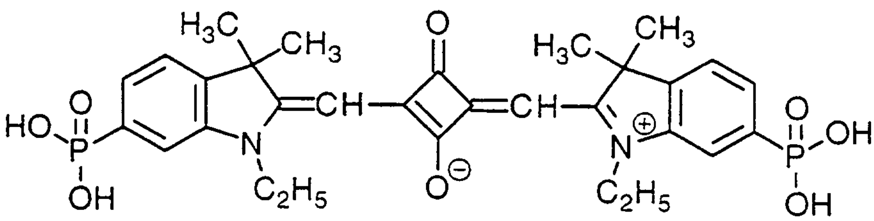

(I-34)

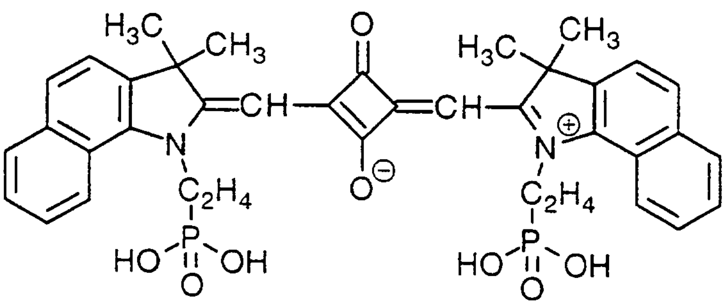

(I-40)

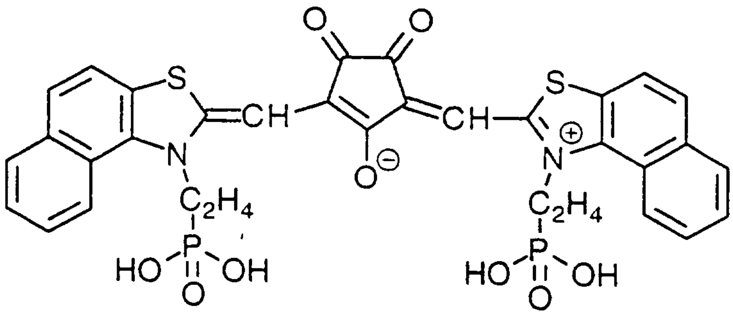

(II-1)

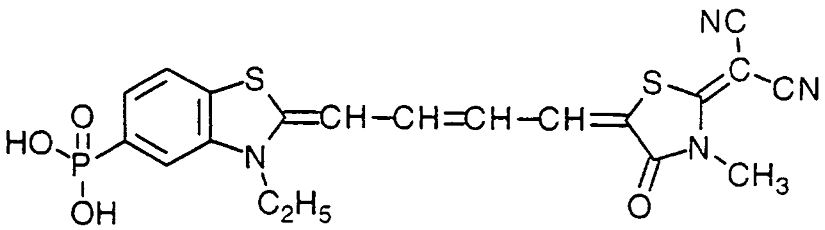

(II-7)

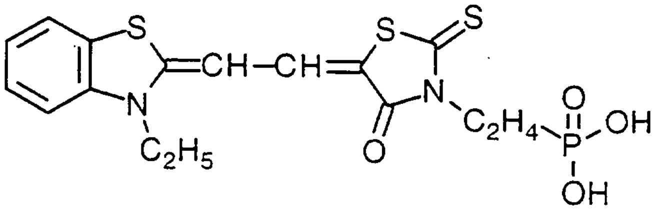

(II-8)

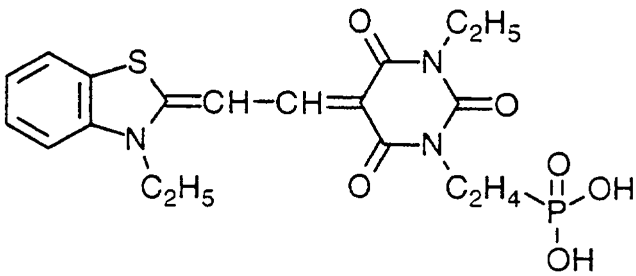

## Claims

1. A semiconductor particle having a surface on which a cyanine dye of the formula (I) is adsorbed:

(I) B=Lo-Bo

in which B is a basic nucleus of the formula (B-I), (B-II), (B-III), (B-IV) or (B-V);

(B-I)

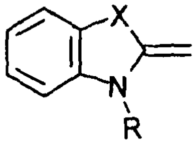

(B-II)

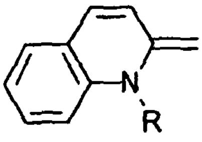

(B-III)

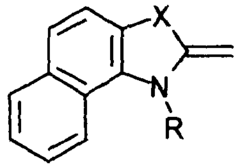

(B-IV)

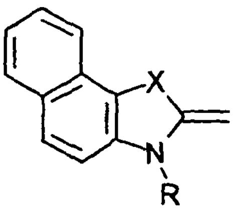

(B-V)

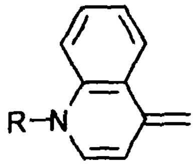

in which X is $-CR_2-$, -NR-, -O-, -S-, -Se- or -Te-; R is an alkyl group or an aryl group; Bo is an onium form of a basic nucleus of the formula (Bo-I), (Bo-II), (Bo-III), (Bo-IV) or (Bo-V);

(Bo-I)

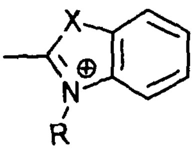

(Bo-II)

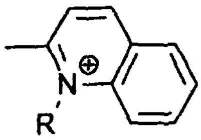

(Bo-III)

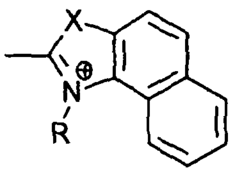

(Bo-IV)

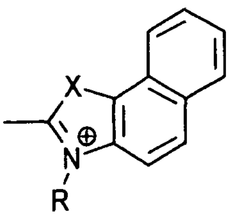

(Bo-V)

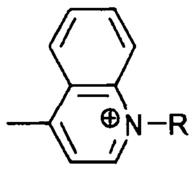

in which X is $-CR_2-$, -NR-, -O-, -S-, -Se- or -Te-; R is an alkyl group or an aryl group; Lo is a methine chain having an odd number of methines; and at least one of B and Bo has the phosphoric group of the formula (P) as a substituent group;

(P)

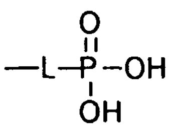

in which L is a single bond, -O-, -S- or -NH-; and the hydrogen atoms may be dissociated from the oxygen atoms.

**2.** The semiconductor particle as defined in claim 1, wherein each of B and Bo has the phosphoric group of the formula (P) as a substituent group.

**3.** A semiconductor particle having a surface on which a merocyanine dye of the formula (II) is adsorbed:

(II) B=Le=A

in which B is a basic nucleus of the formula (B-I), (B-II), (B-III), (B-IV) or (B-V);

(B-I)

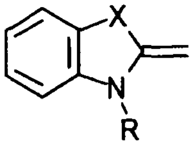

(B-II)

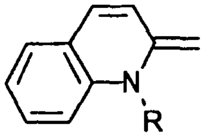

(B-III)

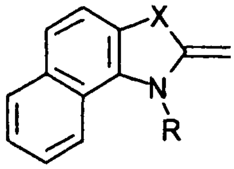

(B-IV)

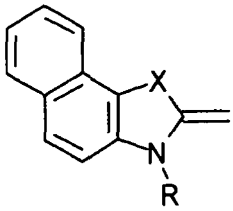

(B-V)

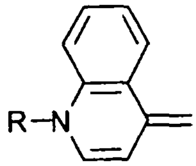

in which X is $-CR_2-$, -NR-, -O-, -S-, -Se- or -Te-; and R is an alkyl group or an aryl group; A is an acidic nucleus of a keto type of the formula (A-I), (A-II) or (A-III);

(A-I)

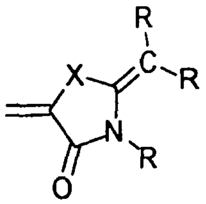

(A-II)

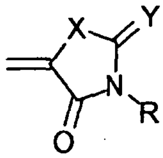

(A-III)

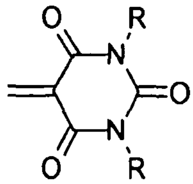

in which X is -NR-, -O-, -S-, -Se- or -Te-; Y is =O or =S; R is hydrogen, an alkyl group, an alkenyl group, an aryl group or cyano; Le is a methine chain having an even number of methines and at least one of B and A has the phosphoric group of the formula (P) as a substituent group;

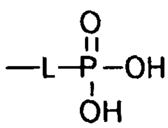

(P)

in which L is a single bond, -O-, -S- or -NH-; and the hydrogen atoms may be dissociated from the oxygen atoms.

4. The semiconductor particle as defined in claim 3, wherein A has the phosphoric group of the formula (P) as a substituent group.

5. A photovoltaic element comprising a conductive support and a light-sensitive layer containing spectrally sensitized semiconductor particles according to claim 1 or claim 3:

6. A photo-electrochemical cell comprising a photovoltaic element, according to claim 5, a charge transfer layer and a counter electrode.

## Patentansprüche

1. Halbleiterteilchen mit einer Oberfläche, an der ein Cyaninfarbstoff der Formel (I) adsorbiert ist:

(I) B=Lo-Bo

in welcher B ein basischer Kern der Formel (B-I), (B-II), (B-III), (B-IV) oder (B-V) ist;

(B-I)

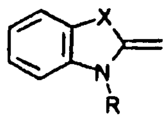

(B-II)

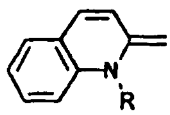

(B-III)

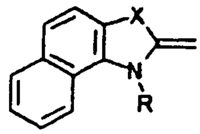

(B-IV)

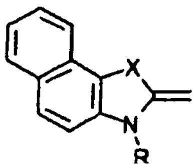

(B-V)

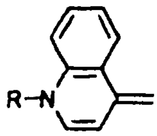

in welchen X $-CR_2-$, -NR-, -O-, -S-, -Se- oder -Te- ist; R eine Alkylgruppe oder eine Arylgruppe ist;
Bo eine Oniumform eines basischen Kerns der Formel (Bo-I), (Bo-II), (Bo-III), (Bo-IV) oder (Bo-V) ist;

(Bo-I)

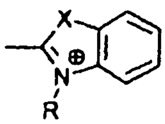

(Bo-II)

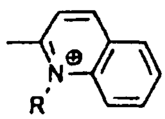

(Bo-III)

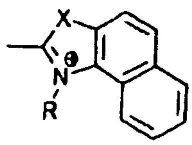

(Bo-IV)

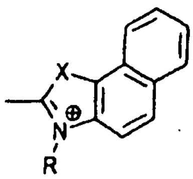

(Bo-V)

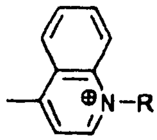

in welchen X $-CR_2-$, -NR-, -O-, -S-, -Se- oder -Te- ist; R eine Alkylgruppe oder eine Arylgruppe ist;

Lo eine Methinkette mit einer ungeraden Anzahl von Methinen ist; und wenigstens eines von B und Bo die phosphorhaltige Gruppe der Formel (P) als Substituentengruppe aufweist;

(P)

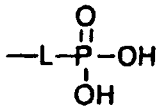

in welcher L eine Einfachbindung, -O-, -S- oder -NH- ist; und die Wasserstoffatome von den Sauerstoffatomen dissoziiert sein können.

2. Halbleiterteilchen nach Anspruch 1, wobei jedes von B und Bo die phosphorhaltige Gruppe der Formel (P) als Substituentengruppe aufweist.

3. Halbleiterteilchen mit einer Oberfläche, an der ein Merocyaninfarbstoff der Formel (II) adsorbiert ist:

(II) B=Le=A

in welcher B ein basischer Kern der Formel (B-I), (B-II), (B-III), (B-IV) oder (B-V) ist;

(B-I)

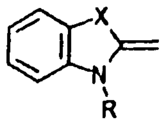

(B-II)

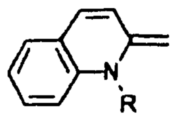

(B-III)

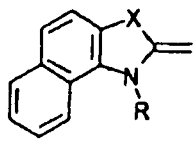

(B-IV)

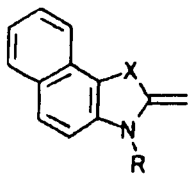

(B-V)

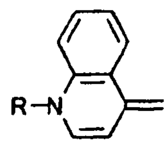

in welchen X $-CR_2-$, -NR-, -O-, -S-, -Se- oder -Te- ist; und R eine Alkylgruppe oder eine Arylgruppe ist;
A ein saurer Kern vom Ketotyp der Formel (A-I), (A-II) oder (A-III) ist;

(A-I)

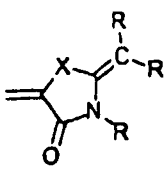

(A-II)

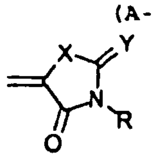

(A-III)

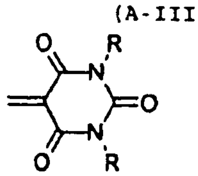

in welchen X -NR-, -O-, -S-, -Se- oder -Te- ist; Y =O oder =S ist; R Wasserstoff, eine Alkylgruppe, eine Alkenylgruppe, eine Arylgruppe oder Cyano ist;
Le eine Methinkette mit einer geraden Anzahl von Methinen ist; und wenigstens eines von B und A die phosphorhaltige Gruppe der Formel (P) als Substituentengruppe aufweist;

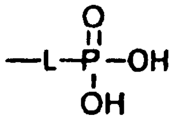

(P)

in welcher L eine Einfachbindung, -O-, -S- oder -NH- ist; und die Wasserstoffatome von den Sauerstoffatomen dissoziiert sein können.

4. Halbleiterpartikel nach Anspruch 3, wobei A die phosphorhaltige Gruppe der Formel (P) als Substituentengruppe aufweist.

5. Photovoltaisches Element, umfassend einen leitfähigen Träger und eine lichtempfindliche Schicht, die spektral sensibilisierte Halbleiterteilchen nach Anspruch 1 oder Anspruch 3 enthält.

6. Photoelektrochemische Zelle umfassend ein photovoltaisches Element nach Anspruch 5, eine Ladungsübertragungsschicht und eine Gegenelektrode.

**Revendications**

1. Particule de semi-conducteur ayant une surface sur laquelle une teinte de cyanine de formule (I) est adsorbée :

(I) **B=Lo-Bo**

dans laquelle B est un noyau basique de formules (B-I), (B-II), (B-III), (B-IV) ou (B-V) ;

(B-I)

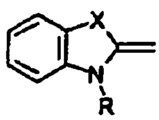

(B-II)

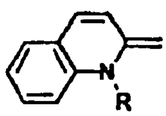

(B-III)

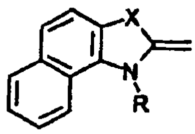

(B-IV)

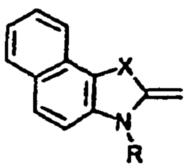

(B-V)

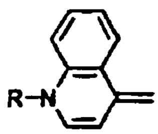

dans lesquelles X est $-CR_2-$, -NR-, -O-, -S-, -Se- ou -Te- ; R est un groupe alkyle ou un groupe aryle ; Bo est une forme d'onium d'un noyau basique de formule (Bo-I), (Bo-II), (Bo-III), (Bo-IV) ou (Bo-V) ;

(Bo-I)

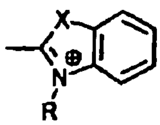

(Bo-II)

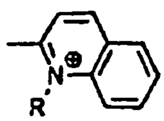

(Bo-III)

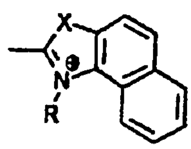

(Bo-IV)

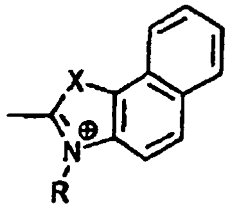

(Bo-V)

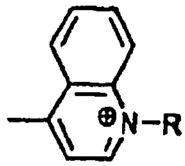

dans lesquelles X est $-CR_2-$, -NR-, -O-, -S-, -Se- ou -Te- ; R est un groupe alkyle ou un groupe aryle ; Lo est une chaîne méthine ayant un nombre impair de méthines ; et au moins l'un de B et de Bo comporte le groupe phosphorique de formule (P) comme groupe substituant ;

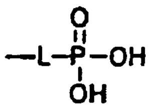

(P)

dans laquelle L est une simple liaison, -O-, -S- ou -NH- ; et les atomes d'hydrogène peuvent être dissociés des atomes d'oxygène.

**2.** Particule de semi-conducteur selon la revendication 1, dans laquelle chacun de B et Bo comporte le groupe phosphorique de formule (P) comme groupe substituant.

**3.** Particule de semi-conducteur ayant une surface sur laquelle une teinte de mérocyanine de formule (II) est adsorbée :

(II) B=Le=A

dans laquelle B est un noyau basique de formules (B-I), (B-II), (B-III), (B-IV) ou (B-V) ;

(B-I)

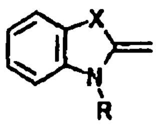

(B-II)

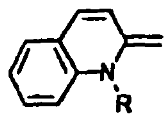

(B-III)

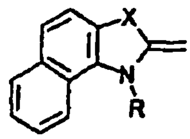

(B-IV)

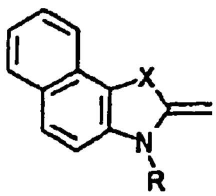

(B-V)

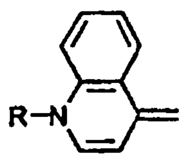

dans lesquelles X est $-CR_2-$, -NR-, -O-, -S-, -Se- ou -Te- ; et R est un groupe alkyle ou un groupe aryle ; A est un noyau acide de type céto de formule (A-I), (A-II) ou (A-III) ;

(A-I)

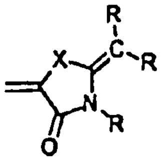

(A-II)

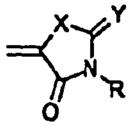

(A-III)

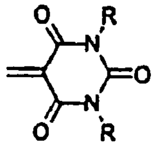

dans lesquelles X est -NR-, -O-, -S-, -Se- ou -Te- ; Y est =O ou =S ; R est un atome d'hydrogène, un groupe alkyle, un groupe alcényle, un groupe aryle ou un groupe cyano ; Le est une chaîne méthine ayant un nombre pair de méthines ; et au moins l'un de B et A comporte le groupe phosphorique de formule (P) comme groupe substituant :

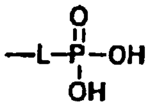

(P)

dans laquelle L est une simple liaison, -O-, -S- ou -NH- ; et les atomes d'hydrogène peuvent être dissociés des atomes d'oxygène.

4. Particule de semi-conducteur selon la revendication 3, dans laquelle A comporte le groupe phosphorique de formule (P) comme groupe substituant.

5. Elément photovoltaïque comprenant un support conducteur et une couche sensible à la lumière contenant des particules de semi-conducteur à sensibilisation spectrale selon la revendication 1 ou la revendication 3.

6. Pile solaire végétale comprenant un élément photovoltaïque selon la revendication 5, une couche de transfert de charge et une contre-électrode.

FIGURE

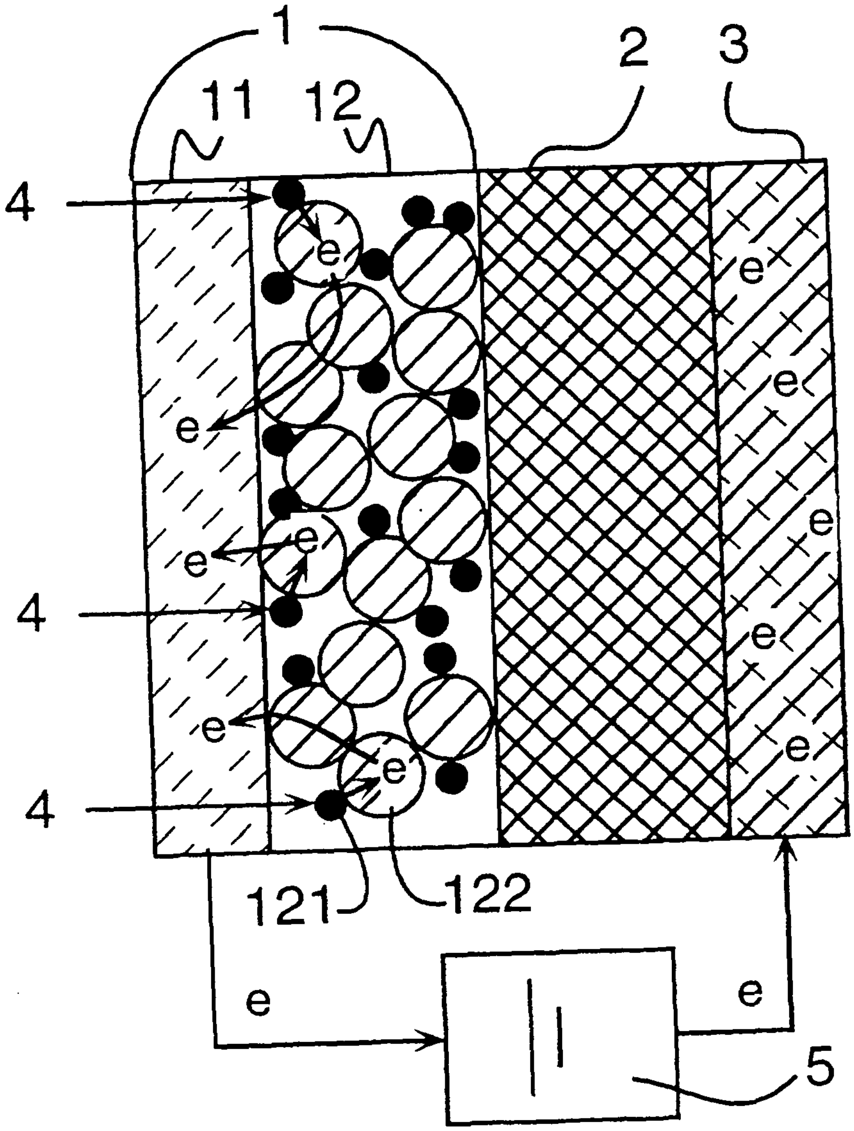

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4684537 A
- US 5084365 A
- US 5350644 A
- US 5463057 A
- US 5525440 A
- JP 7249790 A
- WO 9529924 A
- GB 1077611 A
- US 4927721 A


### Non-patent literature cited in the description


- **F.M. HARMER.** Heterocyclic Compounds-Cyanine Dyes and Related Compounds. John Wiley & Sons, 1964
- **D.M. STURMER.** Heterocyclic Compounds-Special topics in heterocyclic chemistry. John Wiley & Sons, 1977, vol. 18, 482-515
- Rodd's Chemistry of Carbon Compounds. Elsevier Science Publishing Company Inc, 1977, vol. IV, 368-422